# EUROPEAN PATENT APPLICATION

(11) **EP 4 417 738 A1**
(43) Date of publication of application: **21.08.2024**
(21) Application number: 22921648.6
(22) Date of filing: 01.12.2022
(51) Int. Cl.: C30B 25/08, C30B 25/14, C30B 25/12, C30B 29/36

(54) **EPITAXIAL REACTION DEVICE**

(30) Priority: 21.01.2022 CN 202210072642
(71) Applicant: Shenzhen Naso Tech Co., Ltd, Shenzhen, Guangdong 518107 (CN)
(72) Inventor: XIAO, Yunzhang, Shenzhen, Guangdong 518107 (CN); HUANG, Shuaishuai, Shenzhen, Guangdong 518107 (CN); LIU, Lianghui, Shenzhen, Guangdong 518107 (CN); YANG, Fang, Shenzhen, Guangdong 518107 (CN); LIU, Jiaming, Shenzhen, Guangdong 518107 (CN); XU, Xin, Shenzhen, Guangdong 518107 (CN); JING, Junhui, Shenzhen, Guangdong 518107 (CN); CHEN, Bingan, Shenzhen, Guangdong 518107 (CN); ZHONG, Guofang, Shenzhen, Guangdong 518107 (CN)
(74) Representative: Murgitroyd & Company
(86) International application number: PCT/CN2022/135787
(87) International publication number: WO 2023/138224

(57) **Abstract**

Disclosed is an epitaxial reaction device. The epitaxial reaction device includes: a conveying apparatus and at least one reaction apparatus. The reaction apparatus includes a high-temperature reaction chamber, a gas supply module, and a gas extraction module. The high-temperature reaction chamber is used for providing an environmental condition required during wafer processing. The gas supply module and the gas extraction module are oppositely provided in the high-temperature reaction chamber. The gas supply module is used for supplying reaction gas to the high-temperature reaction chamber, and the gas extraction module is used for extracting residual gas. The conveying apparatus is provided on the high-temperature reaction chamber and located on a same side as the gas supply module. The conveying apparatus is used for taking out and placing the wafer.

## Description

### TECHNICAL FIELD

The present disclosure relates to the field of epitaxial layer processing device technologies, and in particular, to an epitaxial reaction device.

### BACKGROUND

An existing silicon carbide epitaxial reaction chamber includes a gas inlet channel, a high-temperature reaction chamber, a gas extraction system, and a wafer reclaiming mechanism sequentially connected. During processing of an epitaxial layer of a wafer, the wafer to be processed is placed in the high-temperature reaction chamber by the reclaiming mechanism. Then, mixed reaction gas is introduced into the high-temperature reaction chamber through the gas inlet channel for reaction, so that a silicon carbide thin film (that is, the epitaxial layer) is formed on a surface of the wafer through a chemical reaction between reaction gas in the high-temperature reaction chamber. Residual raw gas is extracted by the extraction system to ensure a constant gas pressure in the high-temperature reaction chamber. After processing, the wafer is taken out by the reclaiming mechanism.

As there is a temperature difference on wall surfaces, contacting with reactive gas, of the high-temperature reaction chamber, silicon carbides with different crystal may be formed by reaction between the reactive gas in regions with different temperature. Therefore, during processing of an epitaxial layer on a wafer, a dust-like by-product may be produced by a chemical reaction occurred between the high-temperature reaction chamber and the extraction system. Thus, at the beginning and end of each time of wafer processing, the wafer reclaiming mechanism needs to pass through a region where the dust-like by-product exists to put in or take out a wafer tray substrate. However, after long-term operation of the high-temperature reaction chamber, dust particles may not be attached well to an inner wall of the high-temperature reaction chamber, so it is inevitable that foreign objects such as the dust particles may fall off during the process of putting in or taking out. The dust particles and other foreign objects dropped during the process of putting in will ultimately lead to a serious decline in quality of a processed wafer, and even lead to scrapping. The dust particles that fall during the process of taking out will lead to additional cleaning costs.

After long-term use, it is necessary to clean the inner wall of the high-temperature reaction chamber. Due to obstruction of the gas inlet channel and the wafer reclaiming mechanism located in the front and back separately, a special mobile car needs to be designed to transport the entire wafer reclaiming mechanism during disassembly and maintenance, thereby increasing complexity of disassembly and assembly, maintenance time, and leading to high costs and poor reliability.

### SUMMARY

The present application aims to to provide an epitaxial reaction device to solve shortcomings existing in the prior art.

To achieve a purpose mentioned above, the present application provides an epitaxial reaction device used for processing of an epitaxial layer on a wafer. The epitaxial reaction device includes: a conveying apparatus and at least one reaction apparatus.

The reaction apparatus includes a high-temperature reaction chamber, a gas supply module, and a gas extraction module, the high-temperature reaction chamber is configured to provide an environmental condition required during wafer processing, the gas supply module and the gas extraction module are oppositely provided on the high-temperature reaction chamber, the gas supply module is configured to supply reaction gas to the high-temperature reaction chamber, and the gas extraction module is configured to extract residual gas in the high-temperature reaction chamber; and
the conveying apparatus is provided on the high-temperature reaction chamber and located on a same side of the high-temperature reaction chamber as the gas supply module, and the conveying apparatus is configured to put the wafer into the high-temperature reaction chamber and take the wafer out of the high-temperature reaction chamber.

In a possible embodiment, the high-temperature reaction chamber includes a reaction chamber body, a lifting mechanism, and a tray;
the reaction chamber body is respectively connected to the gas supply module, the gas extraction module, and the conveying apparatus;
the lifting mechanism is provided in the reaction chamber body; and
the tray is detachably provided at a lifting end of the lifting mechanism and located in the reaction chamber body, and the tray is used for loading the wafer.

In a possible embodiment, the lifting mechanism includes a lifting execution component and a driving component;
the lifting execution component is provided on a bottom plate of the reaction chamber body and is in sealing fit with the bottom plate, and the tray is detachably provided on the lifting execution component; and
the driving component is connected to the lifting execution component, and the driving component is configured to drive the lifting execution component to rise and fall with the tray in a vertical direction.

In a possible embodiment, the lifting execution component includes a lifting rod, a lifting seat, a bracket, and a scalable sealing sleeve, the sealing sleeve is provided on the bottom plate of the reaction chamber body and is in sealing fit with the bottom plate, the lifting seat is provided at an end, away from the bottom plate, of the sealing sleeve, and the lifting seat is in sealing fit with the sealing sleeve, the lifting rod is inserted into the sealing sleeve, an end of the lifting rod is connected to the lifting seat and the other end of the lifting rod is connected to the bracket, and the tray is detachably disposed on the bracket.

In a possible embodiment, the sealing sleeve is a corrugated pipe.

In a possible embodiment, the lifting mechanism further includes a second driving component, and the second driving component is configured to drive the lifting execution component to rotate with the tray.

In a possible embodiment, a transfer channel is provided between the conveying apparatus and the high-temperature reaction chamber, and a gas supply tube of the gas supply module is provided in the high-temperature reaction chamber; where the transfer channel and the gas supply tube are arranged in a vertical direction.

In a possible embodiment, at least one gas conducting channel is provided in the gas supply tube.

In a possible embodiment, a gate valve is provided on the transfer channel, and the gate valve is configured to close the transfer channel.

In a possible embodiment, a flow rate of reaction gas supplied by the at least one gas conducting channel is separately adjusted.

In a possible embodiment, three gas conducting channels are provided in the gas supply tube, and a width of the gas conducting channel located in the middle is greater than widths of the gas conducting channels located on both sides, and the width of the gas conducting channel located in the middle is greater than or equal to a diameter of the wafer.

In a possible embodiment, the conveying apparatus includes a conveying chamber and a mechanical arm provided in the conveying chamber, and the conveying chamber is connected to the high-temperature reaction chamber, where at least one placing compartment is further provided on the conveying chamber and used for storing the wafer.

In a possible embodiment, a valve is provided on a channel connecting the placing compartment and the conveying chamber.

In a possible embodiment, the mechanical arm includes a fixed seat, a mechanical arm module, and a gripper component;
the fixed seat is provided in the conveying chamber;
the mechanical arm module is rotatably provided on the fixed seat; and
the gripper component is provided on the mechanical arm module,
where the mechanical arm module is configured to drive the gripper component to move in and out of the high-temperature reaction chamber, and the gripper component is used for gripping the wafer.

Compared to the prior art, beneficial effects of the present application are given in the following.

The present application provides an epitaxial reaction device used for processing of an epitaxial layer on a wafer. The epitaxial reaction device includes: a conveying apparatus and at least one reaction apparatus. The reaction apparatus includes a high-temperature reaction chamber, a gas supply module, and a gas extraction module, the high-temperature reaction chamber is configured to provide an environmental condition required during wafer processing, the gas supply module and the gas extraction module are oppositely provided on the high-temperature reaction chamber, the gas supply module is configured to supply reaction gas to the high-temperature reaction chamber, and the gas extraction module is configured to extract residual gas in the high-temperature reaction chamber; and the conveying apparatus is provided on the high-temperature reaction chamber and located on a same side of the high-temperature reaction chamber as the gas supply module, and the conveying apparatus is configured to put the wafer into the high-temperature reaction chamber and take the wafer out of the high-temperature reaction chamber. According to the epitaxial reaction device provided by the present application, by setting the conveying apparatus and the gas supply module on the same side of the high-temperature reaction chamber, there is no need to pass through a region where dust-like by-products exists during putting in or taking out of the wafer, thereby effectively solving a problem of risk in by-products falling onto the wafer.

In addition, during cleaning and maintenance, the high-temperature reaction chamber may be directly disassembled and cleaned without movement of the conveying apparatus and gas supply module, so that a process of cleaning and maintenance may be simplified, thereby reducing costs, ensuring reliable operation, shortening maintenance hours, and indirectly improving production efficiency.

Furthermore, according to the present application, interference between the conveying apparatus and the gas supply module in spatial position may be avoided through a reasonable layout of the conveying apparatus and the gas supply module.

### BRIEF DESCRIPTION OF THE DRAWINGS

In order to illustrate the technical solution of the present application more clearly, accompanying drawings used in embodiments will be briefly described in the following. It should be understood that the accompanying drawings only illustrate certain embodiments of the present application, and should not be regarded as a limitation for a protection scope. For those skilled in the art, other relevant accompanying drawings may be obtained based on these accompanying drawings without any inventive effort.
FIG 1 is a three-dimensional schematic structural diagram of a first type of an epitaxial reaction device according to an embodiment of the present application, with an upper cover of a reaction chamber body and a conveying chamber being hidden.
FIG 2 is a cross-sectional view of a partial structure along A-A shown in FIG 1.
FIG 3 is a partial enlarged schematic diagram at point B shown in FIG 2.
FIG 4 is a three-dimensional schematic structural diagram of a mechanical arm of the type of the epitaxial reaction device shown in FIG 1.
FIG 5 is a three-dimensional schematic structural diagram of a second type of an epitaxial reaction device according to an embodiment of the present application.
FIG 6 is a top view of the second type of the epitaxial reaction device shown in FIG 5.
FIG 7 is a three-dimensional schematic structural diagram of a third type of an epitaxial reaction device according to an embodiment of the present application.
FIG 8 is a schematic structural diagram of a lifting mechanism according to an embodiment of the present application.
FIG 9 is a schematic structural diagram of another lifting mechanism according to an embodiment of the present application.

Numeral reference of main components:
100-conveying apparatus; 110-conveying chamber; 111-placing compartment; 120-mechanical arm; 121-fixed seat; 122-mechanical arm module; 1221-active arm component; 1222-passive arm component; 1223-cantilever rod component; 123-gripper component; 200-reaction apparatus; 210-high-temperature reaction chamber; 211-reaction chamber body; 2110-reaction chamber; 212-lifting mechanism; 2120-lifting execution component; 2120a-lifting rod; 2120b-lifting seat; 2120c-bracket; 2120d-sealing sleeve; 2121-second driving component; 2121a-first driving motor; 2121b-lifting plate; 2121c-nut; 2121d-lifting screw; 2121e-guide rod; 2122-third driving component; 2122a-second driving motor; 2122b-mechanical transmission mechanism; 2122c-rotary table; 2122d-connecting shaft; 2122e-magnetic fluid seal; 213-tray; 220-gas supply module; 221-gas supply tube; 222-gas conducting channel; 230-gas extraction module; 231-gas extraction tube; 300-transfer channel; 400-gate valve; 410-valve core plate; 420-first driving component.

### DETAILED DESCRIPTION OF THE EMBODIMENTS

A detailed description of embodiments of the present disclosure will be given in the following, and examples of the embodiments are shown in the accompanying drawings. The same or similar numeral signs represent the same or similar components or components with the same or similar functions. The embodiments described below with reference to the accompanying drawings are illustrative and only intended to explain the present application, and cannot be understood as limitations of the present application.

In the description of the present application, it should be understood that the orientation or positional relationship indicated by terms such as "center", "longitudinal", "transverse", "length", "width", "thickness", "up", "down", "front", "back", "left", "right", "vertical", "horizontal", "top", "bottom", "inside", "outside", "clockwise", "counterclockwise", "axial", "radial", "circumferential" is based on the orientation or positional relationship shown in the accompanying drawings, and is only for the convenience of describing and simplifying the present application, rather than indicating or implying that a device or a component referred to must have a specific orientation or be constructed and operated in a specific orientation, and therefore cannot be understood as a limitation of the present application.

In addition, the terms "first" and "second" are only used for description and cannot be understood as indicating or implying relative importance or implying the quantity of technical features. Therefore, the features limited by "first" and "second" can explicitly or implicitly include one or more of these features. In the description of the present application, "plurality" means two or more, unless otherwise specified.

In the present application, unless otherwise specified and limited, terms such as "installation", "connected", "connection", "fixation", and so on should be broadly understood. For example, they can be fixed connections, detachable connections, or integrated. They can be a mechanical connection or an electrical connection; They can be directly connected or indirectly connected through an intermediate medium. They can be internal connection of two components or the interaction relationship between two components. For those skilled in the art, the specific meanings of the above terms in the present application should be understood based on specific circumstances.

In the present application, unless otherwise specified and limited, a first feature "above" or "below" a second feature may be understood as directly in contact or indirectly in contact through an intermediate medium. Moreover, the first feature "above", "over" or "on" the second feature may be understood as the first feature directly or diagonally above the second feature, or simply indicate that the horizontal height of the first feature is greater than that of the second feature. The first feature "below", "under" or "beneath" the second feature may be understood as the first feature directly or diagonally below the second feature, or simply indicate that the horizontal height of the first feature is less than that of the second feature.

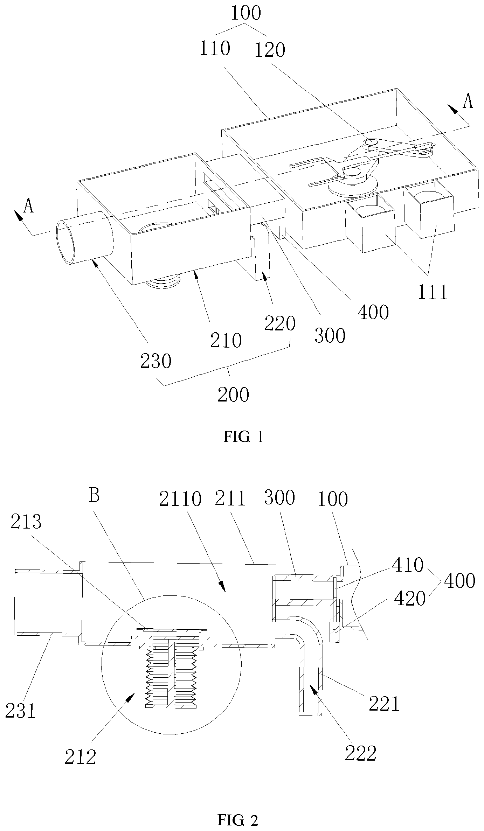

Referring to FIG 1 and FIG 2, an embodiment of the present disclosure provides an epitaxial reaction device used for processing of an epitaxial layer on a wafer.

The epitaxial reaction device provided by the present embodiment includes a conveying apparatus 100 and at least one reaction apparatus 200. Each reaction apparatus 200 is connected to the conveying apparatus 100, namely, the reaction apparatus 200 may be arranged around the conveying apparatus 100. The reaction apparatus 200 is configured to process an epitaxial layer on a wafer. The conveying apparatus 100 is configured to transport a wafer to be processed to each reaction apparatus 200, and the conveying apparatus 100 is further configured to take out the wafer with the epitaxial layer processed from each reaction apparatus 200.

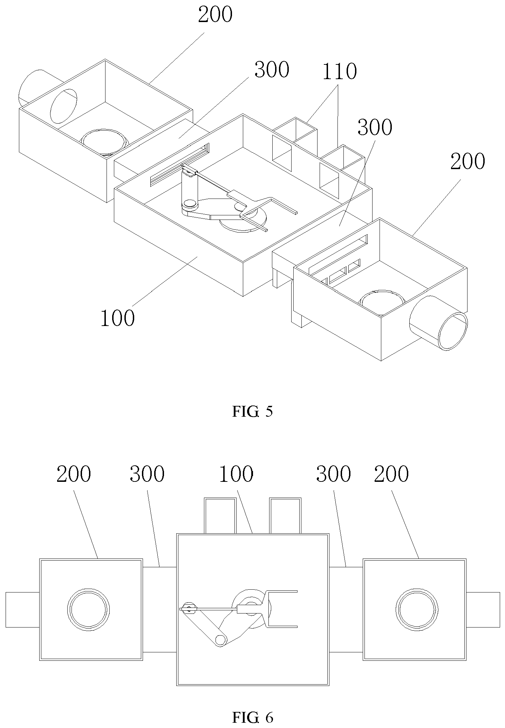

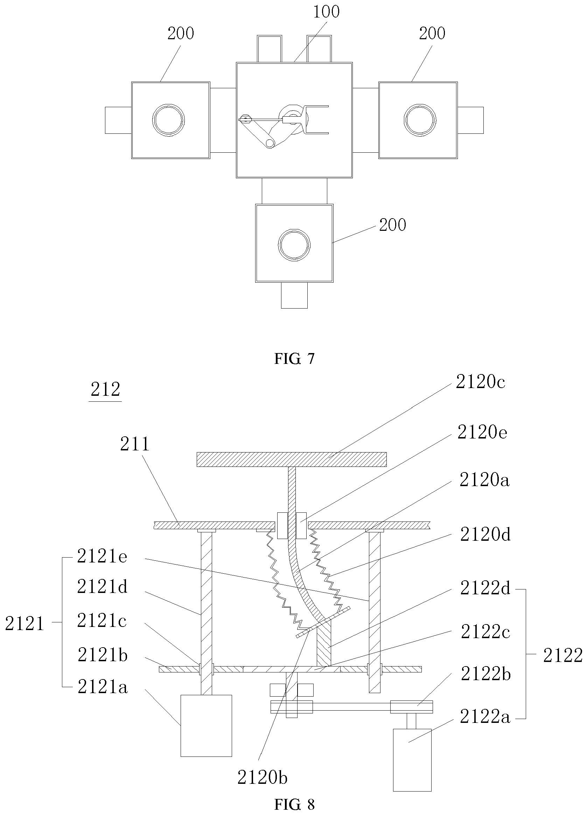

Optionally, referring to FIG 5, FIG 6, and FIG 7 together, a quantity of the reaction apparatus 200 may be one, two, three, four, or more.

Referring to FIG 2, furthermore, the reaction apparatus 200 includes a high-temperature reaction chamber 210, a gas supply module 230, and a gas extraction module 230. The high-temperature reaction chamber 210 is configured to provide an environmental condition required during wafer processing.

The gas supply module 220 and the gas extraction module 230 are provided oppositely or adjacently on a side of the high-temperature reaction chamber 210. In this embodiment, the gas supply module 220 and the gas extraction module 220 are arranged oppositely. During the processing of the epitaxial layer on the wafer, the gas supply module 220 is configured to supply reaction gas to the high-temperature reaction chamber 210. Under the environment provided by the high-temperature reaction chamber 210, a thin film with high performance and fewer defects will be deposited on a surface of the wafer by the reaction gas. The thin film is called an epitaxial layer. After the epitaxial layer is processed, the gas extraction module 230 is configured to extract residual gas in the high-temperature reaction chamber 210 after a reaction.

Referring to FIG 1 and FIG 2, the conveying apparatus 100 is provided on the high-temperature reaction chamber 210 and located on a same side of the high-temperature reaction chamber 210 as the gas supply module 220. During the processing of the epitaxial layer on the wafer, the conveying apparatus 100 is configured to transport a wafer to be processed to the high-temperature reaction chamber 210, and the conveying apparatus 100 is further configured to take out the wafer with the epitaxial layer processed from the high-temperature reaction chamber 210.

Specifically, a transfer channel 300 is provided between the conveying apparatus 100 and the high-temperature reaction chamber 210. The conveying apparatus 100 is configured to transport the wafer through the transfer channel 300.

The gas supply module 220 includes a gas supply sub-system (not shown in figures) and a gas supply tube 221. The gas supply tube 221 is connected to the high-temperature reaction chamber 210, and the gas supply subsystem is connected to the gas supply tube 221. The gas supply sub-system is configured to provide the reaction gas to the high-temperature reaction chamber 210 through the gas supply tube 221.

In this embodiment, the transfer channel 300 and the gas supply tube 221 are arranged in a vertical direction. A gate valve 400 is provided on the transfer channel 300. After the wafer has been transported by the conveying apparatus 100, the gate valve 400 is configured to close the transfer channel 300 to prevent the reaction gas from entering the conveying apparatus 100 through the transfer channel 300.

Optionally, as shown in FIG 2, the transfer channel 300 is located above the gas supply tube 221, so that space may be used reasonably to make an overall epitaxial reaction device more compact. Of course, in some embodiments, the transfer channel 300 may also be located below the gas supply tube 221.

Furthermore, the gas supply tube 221 includes a horizontal section and a vertical section sequentially connected. And the horizontal section is connected with the vertical section through a curved transition connection. Therefore, a space occupied by the gas supply tube 221 in the horizontal direction may be reduced, and a distance between the conveying apparatus 100 and the high-temperature reaction chamber 210 may be shortened, so that a route may be shortened, thereby reducing a risk of contact with a dust-like by-product during a process of putting in or taking out of the wafer.

The gate valve 400 includes a valve core plate 410 and a first driving component 420. The valve core plate 410 is inserted into the transfer channel 300, and the first driving component 420 is connected to the valve core plate 410. The first driving component 420 is configured to drive the valve core plate 410 to move relative to the transfer channel 300, thereby controlling opening and closing of the transfer channel 300.

Optionally, the first driving component 420 may be a gas cylinder, an oil cylinder, a linear motor, or an electric push rod, etc. It should be understood that the above is only an example and not a limitation of a protection scope of the present application.

At least one gas conducting channel 222 is provided in the gas supply tube 221, and an outlet of the at least one gas conducting channel 222 is oriented towards a position where the wafer is placed in the high-temperature reaction chamber 210.

In this embodiment, at least three gas conducting channels 222 are provided, and a flow rate of the reaction gas supplied by each gas conducting channel 222 may be adjusted separately to make the reaction gas supplied more uniform.

It can also be understood that in the high-temperature reaction chamber 210, due to a close distance between an edge of the wafer and a sidewall of the high-temperature reaction chamber 210, a flow velocity at an edge of the wafer is slightly lower than that in the middle of the wafer due to a boundary layer formed when the reactive gas flows, thereby causing poor uniformity of thickness and doping of the thin film deposited. Therefore, by providing the gas supply tube 221 with a plurality of gas conducting channels 222, the flow rate at different positions of the wafer may be more conveniently adjusted to obtain a more uniform epitaxial layer, thereby improving adjustability of process parameters.

Furthermore, as a range of the boundary layer is small, three gas conducting channels 222 are provided in this embodiment. A width of the gas conducting channel 222 located in the middle is greater than widths of the gas conducting channels 222 located on both sides, and the width of the gas conducting channel 222 located in the middle is greater than or equal to a diameter of the wafer. Therefore, while ensuring the supply of the reaction gas in the middle gas conducting channel 222, it is convenient to adjust the flow velocity and the flow rate of the reaction gas in the boundary layer on the sidewall of the high-temperature reaction chamber 210. In addition, the flow rate and the flow velocity of the reaction gas passing through the middle and both sides of the wafer may be adjusted by providing the three gas conducting channels 222. Thus, it is beneficial to obtaining a more uniform epitaxial layer.

In addition, as for a small-sized wafer (such as 4" wafers), according to process validation results, the width of the middle gas conducting channel of the three gas conducting channels 222 has a significant impact on a thickness of the deposited epitaxial layer and the uniformity of doping concentration. When the width of the middle gas conducting channel is greater than a diameter of the 4" wafer, the quality of the deposited thin film on the wafer is higher, and changes in the flow rate at the edge of a gas inlet region have little effect on the quality of the deposited epitaxial layer. Therefore, when the three gas conducting channels 222 are provided, it is required to be wide in the middle and narrow on both sides.

The gas extraction module 220 includes a gas extraction tube 231 and a gas extraction sub-system (not shown in figures) connected to the extraction tube 231. The extraction tube 231 is connected to the high-temperature reaction chamber 210, and the extraction sub-system is configured to extract the residual gas in the high-temperature reaction chamber 210 after reaction.

According to the epitaxial reaction device provided by the present embodiment, by providing the conveying apparatus 100 and the gas supply module 220 on the same side of the high-performance reaction chamber 210, interference between the conveying apparatus 100 and the gas supply module 220 in spatial position may be avoided through a reasonable layout. Furthermore, when the wafer is put in or taken out, there is no need to pass through a region where the dust-like by-products exists, thereby effectively solving a risk of the by-products falling onto the wafer.

Furthermore, during cleaning and maintenance, the high-temperature reaction chamber 210 may be directly disassembled and cleaned without movement of the conveying apparatus 100 and gas supply module 220, thereby saving a separation process for the conveying apparatus 100 and the gas supply module 220. Thus, the cleaning and maintenance process may be simplified, thereby reducing costs, ensuring reliable operation, shortening maintenance hours, and indirectly improving production efficiency.

Referring to FIGS. 1 to 4, the present embodiment further provides an epitaxial reaction device used for processing of an epitaxial layer on a wafer. This embodiment is an improvement made on the basis of the embodiments mentioned above. Compared with the embodiments mentioned above, a difference will be given in the following.

Referring to FIG 1 and FIG 2, in this embodiment, a detailed description will be given with a reaction apparatus 200 as an example. A high-temperature reaction chamber 210 includes a reaction chamber body 211, a lifting mechanism 212, and a tray 213. The reaction chamber body 211 is respectively connected to a gas supply tube 221 of a gas supply module 220, a gas extraction tube 231 of a gas extraction module 220, and a transfer channel 300.

A reaction chamber 2110 is formed in the reaction chamber body 211, and the lifting mechanism 212 is disposed in the reaction chamber 2110 of the reaction chamber body 211. The tray 213 is detachably disposed at a lifting end of the lifting mechanism 212 and located in the reaction chamber body 211. The tray 213 is used for loading the wafer. The lifting mechanism 212 is configured to drive the tray 213 to rise and fall in the reaction chamber 2110, so that the lifting end may be aligned to the transfer channel 300 or an outlet of the gas supply tube 221. Thus, the wafer loaded on the tray 213 may also be aligned to the transfer channel 300 or the outlet of the gas supply tube 221.

Referring to FIG 2, FIG 3, and FIG 8, specifically, the lifting mechanism 212 includes a lifting execution component 2120 and a second driving component 2121. The lifting execution component 2120 is disposed on a bottom plate of the reaction chamber body 211. The second drive component 2121 is configured to drive the lifting execution component 2120 to rise and fall with the tray 213 in the reaction chamber 2110. The second driving component 2121 may be installed on the bottom plate of the reaction chamber body 211, and of course, may also be installed on an external rack (not shown in figures).

The lifting execution component 2120 includes a lifting rod 2120a, a lifting seat 2120b, a bracket 2120c, and a scalable sealing sleeve 2120d. The sealing sleeve 2120d is disposed on the bottom plate of the reaction chamber body 211 and is in sealing fit with the bottom plate of the reaction chamber body 211. The sealing sleeve 2120d is located outside the reaction chamber 2110. The lifting seat 2120b is disposed at an end, away from the bottom plate of the reaction chamber body 211, of the sealing sleeve 2120d. The lifting seat 2120b is in sealing fit with the sealing sleeve 2120d, and the lifting rod 2120a is inserted into the sealing sleeve 2120d. An end of the lifting rod 2120a is connected to the lifting seat 2120b, and the other end is connected to the bracket 2120c. The tray 213 is detachably disposed on the bracket 2120c.

An output end of the second driving component 2121 is connected to the lifting seat 2120b, and the output end of the second driving component 2121 is capable of moving back and forth through linear motion. Therefore, the second driving component 2121 is configured to drive the lifting seat 2120b, the lifting rod 2120a, and the bracket 2120c to rise and fall. As the sealing sleeve 2120d is scalable, the rising and falling motion of the lifting execution component 2120 may be adapted through extension and retraction of the sealing sleeve 2120d.

It can be understood that both ends of the sealing sleeve 2120d are provided with sealing fit, so that external gas leakage into the reaction chamber 2110 or internal reaction gas leakage from the reaction chamber 2110 may be avoided, thereby ensuring the sealing of the reaction chamber 2110, and providing a stable process condition for the wafer.

Optionally, the sealing sleeve 2120d is a corrugated pipe.

Optionally, in this embodiment, the second driving component 2121 is a gas cylinder, an oil cylinder, a linear motor, an electric push rod, a cam mechanism, or a crank slider mechanism, etc. It should be understood that the above is only an example and not a limitation of the protection scope of the present application.

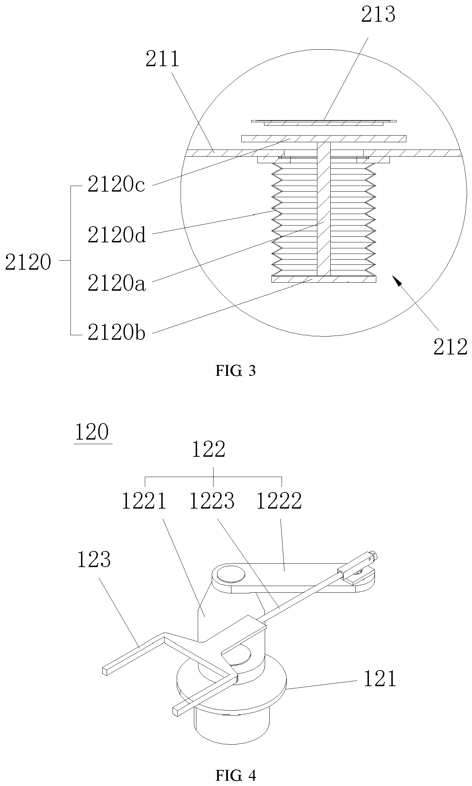

Referring to FIG 1 and FIG 4, the conveying apparatus 100 includes a conveying chamber 110 and a mechanical arm 120 disposed in the conveying chamber 110. The conveying chamber 110 is connected to the reaction chamber body 211 through the conveying channel 300, and the mechanical arm 120 is disposed in the conveying chamber 110. The mechanical arm 120 is configured to retract from or extend into the reaction chamber 2110 through the conveying channel 300 for putting in or taking out the silicon carbide wafer.

Furthermore, at least one placing compartment 111 is further disposed on a side of the conveying chamber 110 and is used for storing the wafer. The placing compartment 111 is connected to the conveying chamber 110. In this embodiment, a quantity of the placing compartment 111 is two, and the two placing compartments 111 are used for storing unprocessed or processed wafers. Therefore, the mechanical arm 120 is further configured to put the wafer in the two placement compartments 111 or take the wafer out of the two placement compartments 111.

In some embodiments, the quantity of the placement compartments 111 may be three, four, five, or more. It should be understood that the above is only an example and not a limitation of the protection scope of the present application. In addition, a valve may be provided on a channel connecting the placing compartment 111 and the conveying chamber 110. When an unprocessed wafer is put in or a processed wafer is taken out of the placing compartment 111, the valve is closed first to cut off the channel between the placing compartment 111 and the conveying chamber 110. When a pressure in the placing compartment 111 is restored to an atmospheric pressure, a door of the placing compartment 111 is opened for operation. When the operation is completed, the placing chamber 111 is restored to a same vacuum or pressure state as the conveying chamber 110.

When the mechanical arm 120 enters the two placing compartments 111 to put in or take out the wafer, the valve opens first. When the action of putting in or taking out is completed and the mechanical arm 120 moves out of the placing compartment 111, the valve closes to cut off the channel between the placing compartment 111 and the conveying chamber 110, thereby ensuring the vacuum state of the conveying chamber 110 and effectively prevent external pollution sources from entering. Thus, the uniformity of the thickness and doping concentration of the epitaxial layer on the processed wafer may be improved, and the yield rate may be increased.

Specifically, the mechanical arm 120 includes a fixed seat 121, a mechanical arm module 122, and a gripper component 123. The fixed seat 121 is disposed in the conveying chamber 110.

The mechanical arm module 122 includes an active arm component 1221, a passive arm component 1222, and a cantilever rod component 1223. The active arm component 1221 is rotatably disposed on the fixed seat 121, the passive arm component 1222 is rotatably disposed on the active arm component 1221, and the cantilever rod component 1223 is rotatably disposed on the passive arm component 1222. The gripper component 123 is located at an end, away from the passive arm component 1222, of the cantilever rod component 1223.

The active arm component 1221, the passive arm component 1222, and the cantilever rod component 1223 are all driven to rotate by a motor, and a rotation plane of the cantilever rod component 1223 is parallel to a plane where the transfer channel 300 is located. In this embodiment, through a rotational fit among the active arm component 1221, the driven arm component 1222, and the cantilever rod component 1223, the cantilever rod component 1223 may drive the gripper component 123 to perform linear telescopic motion in the transfer channel 300.

Optionally, the motor may be a stepper motor or a servo motor.

Therefore, by driving the gripper component 123 to perform linear telescopic motion, the gripper component 123 enters and exits the high-performance reaction chamber 210 correspondingly. The gripper component 123 is used for gripping or placing the wafer.

In this embodiment, when the conveying apparatus 100 transports the wafer, the wafer is placed on the tray 213 and the tray 213 is gripped by the gripper component 123 together with the wafer for transportation. Thus, it can be understood that when the conveying apparatus 100 is used for putting in or taking out the wafer, the lifting mechanism 212 acts to drive the bracket 2120c to rise or fall, so that the bracket 2120c is aligned to the transfer channel 300 and remains in a same plane. Meanwhile, the gate valve 400 is opened, making it easier for the mechanical arm 120 to pick up or place the tray 213 loaded with the wafer. During processing of the epitaxial layer on the wafer, the gate valve 400 is closed and the lifting mechanism 212 acts to drive the bracket 2120c to rise or fall, so that the bracket 2120c is aligned to the gas supply tube 221 and remains in a same plane with the outlet of the gas supply tube 221.

Referring to FIG 2, FIG 3, and FIG 8, the present embodiment further provides an epitaxial reaction device used for processing of an epitaxial layer on a wafer. This embodiment is an improvement made on the basis of the above embodiments. Compared with the above embodiments, the difference will be given in the following.

In this embodiment, the lifting mechanism 212 includes a lifting execution component 2120, a second driving component 2121, and a third driving component 2122. The lifting execution component 2120 is disposed on a bottom plate of the reaction chamber body 211. The second driving component 2121 is disposed on the bottom plate of the reaction chamber body 211, and the third driving component 2122 is disposed on the second driving component 2121 and connected to the lifting seat 2120b. In this embodiment, the second driving component 2121 is configured to drive the lifting execution component 2120 to rise or fall with the tray 213 in the reaction chamber 2110, and the third driving component 2122 is configured to drive the lifting rod 2120a to rotate.

Specifically, the second driving component 2121 includes a first driving motor 2121a, a lifting plate 2121b, a nut 2121c, a lifting screw 2121d, and a guide rod 2121e. The first driving motor 2121a is located below the bottom plate of the reaction chamber body 211. An end of the lifting screw 2121d is rotatably connected to the bottom plate of the reaction chamber body 211, and the other end of the lifting screw 2121d is connected to an output end of the first driving motor 2121a. The lifting plate 2121b is installed on the lifting screw 2121d through the nut 2121c, and the nut 2121c is matched with a threaded pair of the lifting screw 2121d. Therefore, the lifting plate 2121b may be driven to rise and fall along an axial direction of the lifting screw 2121d through a rotational motion output by the first driving motor 2121a. An end of the guide rod 2121e is installed on the bottom plate of the reaction chamber body 211, and the other end of the guide rod 2121e runs through the lifting plate 2121b, and the guide rod 2121e is in sliding fit with the lifting plate 2121b. It should be understood that on one hand, the setting of the guide rod 2121e may limit the rotation of the lifting plate 2121b, and on the other hand, it can provide guidance for the lifting plate 2121b, thereby ensuring stability of the rising and falling of the lifting plate 2121b.

The third driving component 2122 includes a second driving motor 2122a, a mechanical transmission mechanism 2122b, a rotary table 2122c, and a connecting shaft 2122d. The second driving motor 2122a is installed on the lifting plate 2121b, and the rotary table 2122c is rotatably disposed on the lifting plate 2121b. The second driving motor 2122a is connected with the rotary table 2122c through the mechanical transmission mechanism 2122b. The second driving motor 2122a is configured to drive the rotary table 2122c to rotate relative to the lifting plate 2121b through the mechanical transmission mechanism 2122b. And the connecting shaft 2122d is eccentrically disposed on the rotary table 2122c, and an upper end of the connecting shaft 2122d is connected to the lifting seat 2120b.

Furthermore, the mechanical transmission mechanism 2122b may be selected as a sprocket transmission mechanism, a belt pulley transmission structure, a gear transmission mechanism, or a worm gear transmission mechanism, etc. It should be understood that the above is only an example and not a limitation of the protection scope of the present application.

Furthermore, in this embodiment, the lifting rod 2120a is cooperated with the bottom plate of the reaction chamber body 211 through a linear bearing 2120e to reduce friction during rising and falling of the lifting rod 2120a. An end, away from the bottom plate of the reaction chamber 211, of the lifting rod 2120a is bent away from the axial direction, and the length of a straight section of the lifting rod 2120a is greater than or equal to a maximum route of rising and falling. The sealing sleeve 2120d is a corrugated pipe adapt to a shape of the lifting rod 2120a. The lifting rod 2120a is connected to the lifting seat 2120b, and a rotation center line of the lifting rod 2120a coincides with a rotation center line of the rotary table 2122c.

Therefore, when the rotary table 2122c rotates, the lifting seat 2120b and the lifting rod 2120a may be driven to rotate together by the connecting shaft 2122d, and then the bracket 2120c may be driven to rotate with the tray 213 by the lifting rod 2120a. The corrugated pipe possesses a certain degree of flexibility and is capable of self-adapting during swinging. Therefore, the epitaxial reaction device provided in this embodiment integrates functions of lifting and rotating. During the processing of the epitaxial layer on the wafer, temperature distribution on the surface of the wafer may be more uniform through rotation of the wafer on the tray 213, so that uniformity of a thickness and doping concentration of the epitaxial layer during epitaxial growth may be improved.

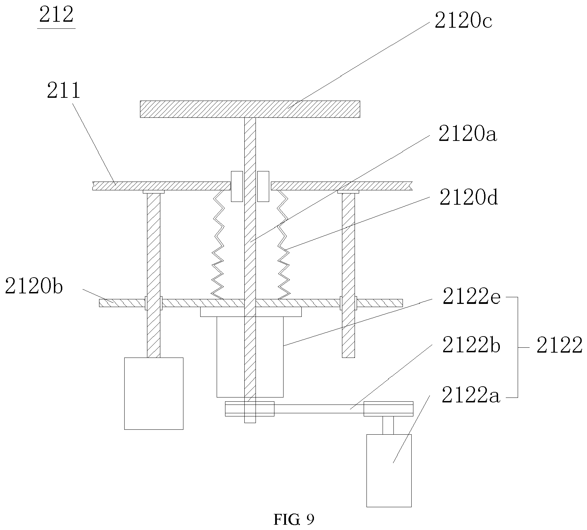

Referring to FIG 2, FIG 3, FIG 8, and FIG 9, the present embodiment further provides an epitaxial reaction device for processing of an epitaxial layer on a wafer. This embodiment is an improvement made on the basis of the above embodiments. Compared with the above embodiments, the difference will be given in the following.

In this embodiment, the lifting plate 2121b in the second driving component 2121 may be directly replaced by the lifting seat 2120b in the lifting execution component 2120, thereby omitting the lifting plate 2121b in the second driving component 2121 and simplifying the structure.

A third driving component includes a second driving motor 2122a, a mechanical transmission mechanism 2122b, and a magnetic fluid seal 2122e. The lifting rod 2120a passes through the lifting seat 2120b and is in rotational fit with the lifting seat 2120b through the magnetic fluid seal 2122e. The magnetic fluid seal 2122e may prevent leakage of the reaction chamber body 211. The second driving motor 2122a is connected to the lifting rod 2120a exposed outside the magnetic fluid seal 2122e through the mechanical transmission mechanism 2122b. The lifting rod 2120a and the bracket 2120c may be driven by the second driving motor 2122a through the mechanical transmission mechanism 2122b to rotate with the tray 213 disposed on the bracket 2120c.

Furthermore, the mechanical transmission mechanism 2122b may also be selected as a sprocket transmission mechanism, a belt pulley transmission structure, a gear transmission mechanism, a worm gear transmission mechanism and so on as the embodiment mentioned above. It should be understood that the above is only an example and not a limitation of the protection scope of the present application.

In the description of this specification, the terms such as "one embodiment", "some embodiments", "examples", "specific examples", or "some examples" means that the specific features, structures, materials, or characteristics described in the embodiments or examples are included in at least one embodiment or example of the present application. In this specification, the illustrative expressions of the above terms do not necessarily refer to the same embodiments or examples. Moreover, the specific features, structures, materials, or characteristics described can be combined in an appropriate manner with any one or more embodiments or examples. In addition, those skilled in the art may combine and integrate the different embodiments or examples described in this specification, as well as the features of different embodiments or examples, under the condition that they do not contradict each other.

Although the embodiments of the present application have been shown and described above, it can be understood that the above embodiments are exemplary and cannot be understood as limitations to the present application. Those skilled in the art may make changes, modifications, substitutions, and variations to the above embodiments within the scope of the present application.

## Claims

1. An epitaxial reaction device used for processing of an epitaxial layer on a wafer, comprising a conveying apparatus and at least one reaction apparatus;
wherein the reaction apparatus comprises a high-temperature reaction chamber, a gas supply module, and a gas extraction module, the high-temperature reaction chamber is configured to provide an environmental condition required during wafer processing, the gas supply module and the gas extraction module are oppositely provided on the high-temperature reaction chamber, the gas supply module is configured to supply reaction gas to the high-temperature reaction chamber, and the gas extraction module is configured to extract residual gas in the high-temperature reaction chamber; and
the conveying apparatus is provided on the high-temperature reaction chamber and located on a same side of the high-temperature reaction chamber as the gas supply module, and the conveying apparatus is configured to put the wafer into the high-temperature reaction chamber and take the wafer out of the high-temperature reaction chamber.

2. The epitaxial reaction device according to claim 1, wherein the high-temperature reaction chamber comprises a reaction chamber body, a lifting mechanism, and a tray;
the reaction chamber body is respectively connected to the gas supply module, the gas extraction module, and the conveying apparatus;
the lifting mechanism is provided in the reaction chamber body; and
the tray is detachably provided at a lifting end of the lifting mechanism and located in the reaction chamber body, and the tray is used for loading the wafer.

3. The epitaxial reaction device according to claim 2, wherein the lifting mechanism comprises a lifting execution component and a driving component;
the lifting execution component is provided on a bottom plate of the reaction chamber body, the lifting execution component is in sealing fit with the bottom plate, and the tray is detachably provided on the lifting execution component; and
the driving component is connected to the lifting execution component, and the driving component is configured to drive the lifting execution component to rise and fall with the tray in a vertical direction.

4. The epitaxial reaction device according to claim 3, wherein the lifting execution component comprises a lifting rod, a lifting seat, a bracket, and a scalable sealing sleeve, the sealing sleeve is provided on the bottom plate of the reaction chamber body and is in sealing fit with the bottom plate, the lifting seat is provided at an end, away from the bottom plate, of the sealing sleeve, and the lifting seat is in sealing fit with the sealing sleeve, the lifting rod is inserted into the sealing sleeve, an end of the lifting rod is connected to the lifting seat and the other end of the lifting rod is connected to the bracket, and the tray is detachably disposed on the bracket.

5. The epitaxial reaction device according to claim 4, wherein the sealing sleeve is a corrugated pipe.

6. The epitaxial reaction device according to any one of claims 3 to 5, wherein the lifting mechanism further comprises a second driving component, and the second driving component is configured to drive the lifting execution component to rotate with the tray.

7. The epitaxial reaction device according to any one of claims 1 to 6, wherein a transfer channel is provided between the conveying apparatus and the high-temperature reaction chamber, and a gas supply tube of the gas supply module is provided in the high-temperature reaction chamber.

8. The epitaxial reaction device according to claim 7, wherein the transfer channel and the gas supply tube are arranged in a vertical direction.

9. The epitaxial reaction device according to claim 7 or 8, wherein at least one gas conducting channel is provided in the gas supply tube.

10. The epitaxial reaction device according to any one of claims 7 to 9, wherein a gate valve is provided on the transfer channel, and the gate valve is configured to close the transfer channel.

11. The epitaxial reaction device according to claim 9 or 10, wherein a flow rate of reaction gas supplied by the at least one gas conducting channel is separately adjusted.

12. The epitaxial reaction device according to any one of claims 9 to 11, wherein three gas conducting channels are provided in the gas supply tube, and a width of the gas conducting channel located in the middle is greater than widths of the gas conducting channels located on both sides, and the width of the gas conducting channel located in the middle is greater than or equal to a diameter of the wafer.

13. The epitaxial reaction device according to any one of claims 1 to 12, wherein the conveying apparatus comprises a conveying chamber and a mechanical arm provided in the conveying chamber, and the conveying chamber is connected to the high-temperature reaction chamber.

14. The epitaxial reaction device according to any one of claims 1 to 13, wherein at least one placing compartment is further provided on the conveying chamber and used for storing the wafer.

15. The epitaxial reaction device according to claim 14, wherein a valve is provided in a channel connecting the placing compartment and the conveying chamber.

16. The epitaxial reaction device according to any one of claims 13 to 15, wherein the mechanical arm comprises a fixed seat, a mechanical arm module, and a gripper component;
the fixed seat is provided in the conveying chamber;
the mechanical arm module is rotatably provided on the fixed seat; and
the gripper component is provided on the mechanical arm module,
wherein the mechanical arm module is configured to drive the gripper component to move in and out of the high-temperature reaction chamber, and the gripper component is used for gripping the wafer.
